Europäisches Patentamt

European Patent Office

Office européen des brevets

(19)

(11) Publication number: **0 225 717**
A1

# EUROPEAN PATENT APPLICATION

(21) Application number: 86308472.9

(22) Date of filing: 30.10.86

(51) Int. Cl.⁴: **H 01 J 37/317,** H 01 J 49/30, H 01 J 37/145, H 01 L 21/265

(30) Priority: 01.11.85 US 794021

(43) Date of publication of application: 16.06.87
Bulletin 87/25

(84) Designated Contracting States: DE FR GB NL

(71) Applicant: **VARIAN ASSOCIATES, INC., 611 Hansen Way,**
**Palo Alto, CA 94303 (US)**

(72) Inventor: **Mobley, Richard M., 22 Gould Court,**
**Gloucester Massachusetts (US)**

(74) Representative: **Cline, Roger Ledlie et al, EDWARD**
**EVANS & CO. Chancery House 53-64 Chancery Lane,**
**London WC2A 1SD (GB)**

(54) High current mass spectrometer using space charge lens.

(57) Charged particle beam apparatus includes a source 6, 8,
10, 12, 14 for forming a charged particle beam 18 along a
beam axis, a mass analyzing magnet 22 for imposing on the
beam 18 a magnetic field perpendicular to the beam axis, a
resolving slit 24 downstream of the analyzing magnet 22 and
a space charge lens 20 positioned between the source and the
analyzing magnet in close proximity to the magnet entrance.
The apparatus provides a mass spectrometer with high current
capability while maintaining the size and weight of the system
within acceptable limits. The apparatus is particularly useful in
ion implantation systems.

-1-

## High Current Mass Spectrometer
## Using Space Charge Lens

This invention relates to the field of ion optics and, more particularly, to a mass spectrometer for separating ion species according to mass which utilizes a space charge lens to reduce size and weight and to increase current-handling capability.

Mass spectrometers are used in a variety of charged particle beam applications, such as material analysis instruments and high energy accelerators. Typically, spectrometers are used at relatively low ion currents. However, in ion implantation of semiconductor devices, high current mass spectrometers are required.

Ion implantation has become a standard technique for introducing impurity dopants into semiconductor wafers. A beam of ions is generated in a source and is directed with varying degrees of acceleration toward a target wafer. Ion implantation systems typically include an ion source, ion optics for removing undesired ion species and for focusing the beam, means for deflecting the ion beam over the target area and an end station for mounting and exchanging wafers. Mass spectrometers are required in ion implanters to eliminate the undesired species generated in the ion source from contaminating the semiconductor devices and adversely affecting device parameters and operation.

One of the requirements for commercial ion implantation equipment is to achieve high throughput in terms of wafers implanted per unit time. This is accomplished, in part, by increasing the ion beam current applied to the device, thereby reducing the time required to implant a given ion dosage. As the current is increased, the elements of the ion beam generating system, particularly magnetic elements and power supplies, become larger and heavier and consume more power. One such element is the mass analysis magnet system and associated power supply. Typically, 90° bending magnets are utilized in ion implanters to separate the desired species from undesired species generated in the source. These mass analysis magnets must accommodate a variety of different ion species and can weigh up to 6000 pounds for ion currents of 20 milliamperes.

Another factor in commercial ion implantation systems is the size of the system, particularly in terms of required floor space. Ion implanters are operated in clean rooms where floor space is at a premium. It is desirable, therefore, to keep the size of the ion implanter at a minimum. The size, weight and ion optical lengths of the mass analysis magnet contribute significantly to the overall size and weight of the ion implanter. Mass spectrometer configurations which reduce size and weight, while maintaining high current capability, are thus desirable.

A double focusing mass spectrometer utilizing an electrostatic lens for separating ions according to energy and a mass analyzing magnet for separating ions according to mass, is disclosed by Matsuda in U.S. Patent No. 4,078,176. The disclosed arrangement is unsuitable for high current operation. An ion beam apparatus utilizing a space charge lens positioned near an ion source extractor is disclosed by H. W. Lefevre et al, *IEEE Trans. Nucl. Sci.*, Vol. NS-26, No. 3, June 1979, pages 3115-3117. Apparently, the lens is used to obtain a low divergence beam.

It is a general object of the present invention to provide a novel, high current mass spectrometer.

It is another object of the present invention to provide a novel mass spectrometer of relatively small size and weight.

It is yet another object of the present invention to provide a novel, high current mass spectrometer utilizing a space charge lens.

## Summary of the Invention

According to the present invention, these and other objects and advantages are achieved in a charged particle beam apparatus comprising source means for forming a charged particle beam along a beam axis, magnetic means for imposing on the charged particle beam a magnetic field having a component perpendicular to the beam axis for deflecting the charged particles according to mass, a resolving slit positioned downstream of the magnetic means so as to pass charged particles of a selected mass, and space charge lens means positioned between the source means and the magnetic means in close proximity to the entrance to the magnetic means for focusing the charged particle beam in the plane of the resolving slit. The space charge lens means includes means for generating electrostatic and magnetic fields for confining an electron cloud having a generally uniform spatial distribution within a region traversed by the beam.

## Brief Description of the Drawings

For a better understanding of the present invention together with other and further objects, advantages and capabilities thereof, reference may be had

-4-

to the accompanying drawings which are incorporated herein by reference and in which:

FIG. 1 is a schematic diagram of an ion implantation system utilizing the present invention; and

FIG. 2 is a simplified schematic diagram of the apparatus of the present invention in the vertical plane.

Detailed Description of the Invention

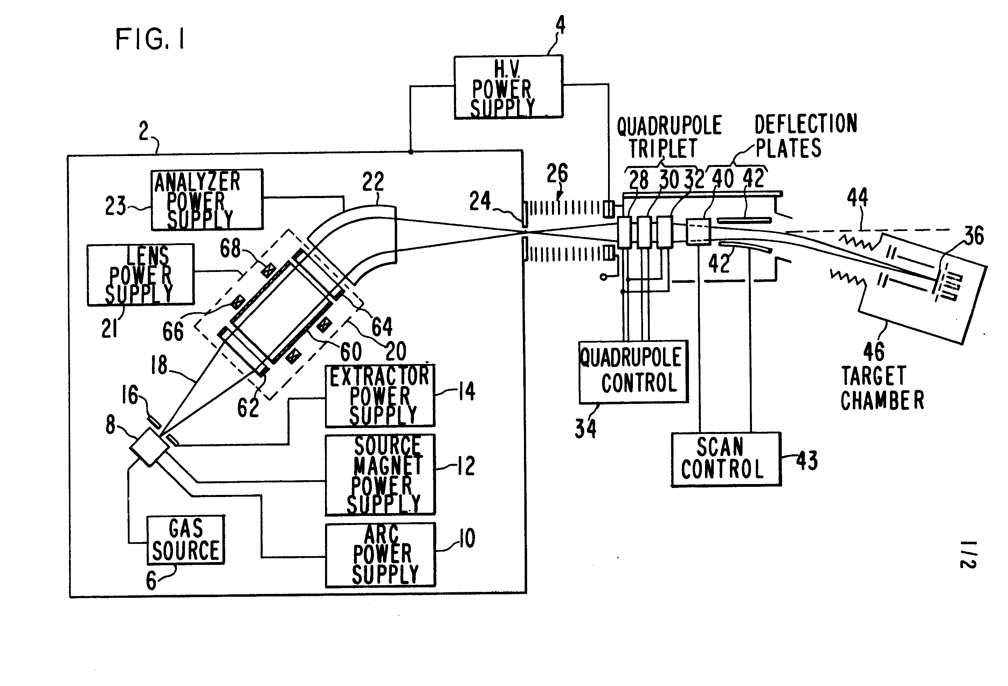

An ion implantation system utilizing the present invention is shown in FIG. 1. A high voltage terminal 2 is held at high potential relative to ground by a high voltage power supply 4. The terminal 2 contains ion source apparatus required to form a beam of ions of a desired species. In common practice, an ion source 8 is provided to ionize a gas derived from a gas source 6 or to vaporize a solid material. A typical ion source requires an arc power supply 10 to sustain an ionizing discharge, a source magnet power supply 12 to impose an axial magnetic field across the discharge region, and an extractor power supply 14 to cooperate with an extraction electrode 16 to shape the electric field at the aperture of the ion source, thus achieving effective extraction of a well-defined high current ion beam from the ion source. A variety of ion sources are known in the art; see for example, Aitken, "Ion Sources," Ion Implantation Techniques, Springer-Verlag 1982.

An ion beam 18 diverging from the source 8 passes through a space charge lens 20 energized by a lens power supply 21 and then is momentum analyzed in an analyzer magnet 22, which is energized by an analyzer power supply 23. The analyzed beam passes through a resolving slit 24 to an accelerator tube 26, where it encounters a carefully designed field gradient from the high voltage terminal to ground potential. Optical elements such as a quadrupole lens which may take the form of a quadrupole triplet 28, 30, 32, or other focusing elements, and an associated control system 34 operate to produce a spatial and energy focus at a target 36. A deflection system comprising x axis and y axis electrostatic deflection plates 40, 42 scans the beam over the desired area of the target 36. The waveforms applied to the deflection plates, and their synchronization to form the desired scanning program, are generated by a scan control system 43. The beam 18 is deflected by a fixed angle from axis 44 sufficient to completely separate the beam from a neutral component arising principally from charge exchange collisions between residual gases and the charged particles in the beam. A target chamber 46 contains beam defining apertures, beam monitoring and integrating apparatus, and equipment for introducing the target, typically a semiconductor wafer, into the vacuum system and positioning and cooling the wafer during ion implantation. The target 36 can be mounted by any convenient means, but is typically clamped at its periphery to a platen which acts as a heat sink for energy received from the beam. It will be understood that the entire region traversed by the ion beam between the source and the target is maintained at high vacuum by a vacuum pumping apparatus (not shown).

In accordance with the present invention, the space charge lens 20 is positioned between the source 8 and the analyzing magnet 22 in close proximity to the entrance of the analyzing magnet 22. The space charge lens 20 and the analyzing magnet 22 cooperate to focus the beam 18 in the plane of the resolving slit 24. As is well known in the art, analyzing magnets can focus a charged particle beam as well as deflect the beam according to mass. By appropriate shaping of the entrance and exit poles, the beam can be focused in both the horizontal and vertical planes. The prior art ion implanters have typically utilized analyzing magnets with 90° beam deflection to obtain sufficient mass resolution, while keeping the position of the resolving slit acceptably close. For high current ion beams, however, the analyzing magnet and its associated power supplies are extremely large and heavy and require large amounts of energy. In accordance with the present invention, the ion beam is focused principally by the space charge lens 20. Analyzing magnet 22 contributes to the focusing, but to a lesser degree than the lens 20. Space charge lens 20 is positioned directly in front of the analyzing magnet 22 so as to focus the beam at the resolving slit 24. The analyzing magnet 22 can be made smaller and have a smaller deflection angle for a given current and mass resolution without lengthening the apparatus. Alternatively, the geometrical configuration of the analyzer magnet can be modified to increase current capability without lengthening the apparatus or increasing the size and weight of the magnet.

The basic elements of the space charge lens 20 are illustrated in FIG. 1. The operation of a space charge lens, or Gabor lens, is generally known in the art and has been described by R. M. Mobley et al, IEEE Trans. Nucl. Sci., Vol. NS-26, No. 3, June 1979, pages 3112-3114 and R. Booth et al, Nucl. Instrum.

Methods, Vol. 151, 1978, pages 143-147. Space charge lenses employ electrostatic and magnetic fields to confine a cloud of electrons within a prescribed region. When the electrons are uniformly distributed in an axially symmetric region, a radial electric field exists in the electron cloud, the magnitude of which is proportional to the distance from the axis. As a result, the electron cloud exerts on moving charged particles a force which is proportional to radius, and thereby acts as a lens.

With reference to FIG. 1, the space charge lens 20 includes a cylindrical center electrode 60 which is biased at approximately 1-10 kilovolts. Cylindrical electrodes 62, 64, positioned at opposite ends of, and axially aligned with, center electrode 60, are grounded. Current carrying coils 66, 68 are positioned around the outside of the cylindrical electrode 60. Coils 66, 68 can be of the Helmholtz type which produce a generally uniform axial magnetic field within the cylindrical electrode 60. A magnetic field of 200 gauss is typically required. As a result of the crossed magnetic and electric fields within the electrode 60, a cloud of electrons is trapped therein and is prevented from escaping by the grounded electrodes 62, 64. The electron cloud produces the radial electric field. It will be understood that other electrode configurations can be utilized in the practice of the present invention with the criteria being that electrostatic and magnetic fields are generated which confine a cloud of electrons within a prescribed volume so as to produce a radial electric field which increases in magnitude with increasing radius.

The increased current capability provided by the present invention is described with reference to FIG.

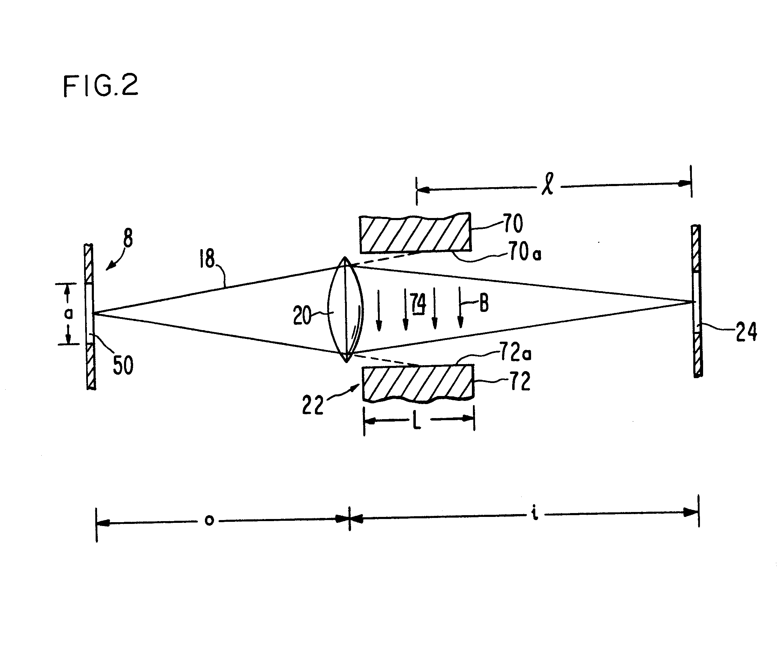

2, which shows a schematic view of the apparatus of the present invention in the vertical plane. Bending and mass separation of the beam occur in the horizontal plane perpendicular to the paper. The analyzer magnet 22 includes an upper pole 70 and a lower pole 72, separated by a gap 74. The faces 70a, 72a of the poles 70, 72 are generally parallel and planar. A magnetic field B exists in the gap 74 perpendicular to the poles 70, 72. The beam 18 passes between the plates 70, 72, perpendicular to the magnetic field B. The magnetic field causes positive ions in the beam 18 to be deflected out of the plane of the paper. The beam 18 emanating from the source 8 diverges in both the vertical and horizontal planes. To obtain adequate mass resolution and current capability, the source 8 aperture is typically an elongated slit 50 with its long dimension a perpendicular to the pole faces 70a, 72a. The current in the beam 18 is increased by lengthening the slit 50, thus requiring the spacing of poles 70, 72 to be increased for passage of the beam current. In order to maintain the same magnetic field B, the poles 70, 72 and associated windings must be increased in size. Without the space charge lens 20, the diverging characteristic of the beam 18 causes a portion of the beam 18 to strike the poles 70, 72, as indicated by the dashed lines in FIG. 2, and the beam current is reduced. By the use of the space charge lens 20 in front of the analyzing magnet 22, the beam 18 is changed from diverging to converging, thereby eliminating the tendency of the beam to strike the magnet poles 70, 72 and preventing loss of beam current. Furthermore, more beam current can be passed through an analyzer magnet of given gap 74 dimension. The acceptance phase-space of a magnet channel of gap g and length L is proportional to $\dfrac{g^2}{L}$. Thus, a shorter L for a given g increases the acceptance, but a larger g increases the acceptance with a squared effect. A magnet with L/2 and 2g, compared to a magnet with L and g, will have an acceptance of 8 times greater.

In prior art systems utilizing an analyzing magnet to perform both mass resolution and focusing, it was extremely.difficult to optimize both focus and mass resolution. The present invention provides capability to use a relatively small analyzing magnet for mass resolution and to control the focusing of the beam at the resolving slit 24 by adjusting the parameters of the space charge lens 20. Thus, focus and mass resolution can be adjusted more or less independently for optimum operation. The width $w_i$ of the image of the source slit 50 at the resolving slit 24 is determined by the magnification of the lens 20

$$w_i = \frac{i}{o} \, w_s$$

where $w_s$ = width of source exit slit 50

$i$ = image distance

$o$ = source object distance

The mass resolution $\dfrac{M}{\Delta M}$ of the apparatus shown in FIG. 2 is given by

$$\frac{M}{\Delta M} = \frac{\theta l o}{2 i w_s}$$

where $\theta$ = bending angle of magnet 22

$l$ = distance from magnet 22 to resolving slit 24.

As an example of the present invention, a mass spectrometer having a 20 milliampere beam current capability for arsenic and phosphorus ions utilizes a 45° bending magnet to give a mass resolution of 110.

The magnet weight is less than 2300 pounds. The space charge lens provides additional focusing to obtain a short optical length to the resolving slit. In the present example, the space between the source and the space charge lens is 14 inches, while the distance from the source to the resolving slit is 45 to 50 inches.

According to another embodiment of the present invention, the mass analyzing magnet is divided into two sections and the space charge lens is positioned between the two sections.

While there has been shown and described what is at present considered the preferred embodiments of the invention, it will be obvious to those skilled in the art that various changes and modifications may be made therein without departing from the scope of the invention as defined by the appended claims.

## CLAIMS

1. A high current mass spectrometer comprising:

a mass analysis magnet for imposing a magnetic field on an ion beam supplied from an ion source, the magnetic field having a component perpendicular to the ion beam axis for deflecting the ions in the beam according to mass; and

space charge lens means positioned in close proximity to the entrance of the mass analysis magnet for focusing the ion beam entering the magnet so as to increase the current passing capability of the magnet, said space charge lens means including means for generating electrostatic and magnetic fields for confining an electron cloud having a generally uniform spatial distribution within a region traversed by the beam.

2. Charged particle beam apparatus comprising:

source means for forming a charged particle beam along a beam axis, said beam having a prescribed angular divergence;

magnetic means for imposing on the charged particle beam a magnetic field having a component perpendicular to the beam axis for deflecting the charged particles according to mass;

a resolving slit positioned downstream of the magnetic means so as to pass charged particles of a selected mass; and

space charge lens means positioned between the source means and the magnetic means in close proximity to the entrance to the magnetic means for focusing the charged particle beam in the plane of the resolving slit, said space charge lens means including means for generating electrostatic and magnetic fields for confining an electron cloud having a generally uniform spatial distribution within a region traversed by the beam.

3. Charged particle beam apparatus as defined in claim 2 wherein said magnetic means comprises a pair of generally parallel pole pieces and a power supply for energizing said pole pieces to generate said magnetic field.

4. Charged particle beam apparatus as defined in claim 3 wherein said space charge lens means comprises cylindrical electrodes for generating an electric field and current-carrying coils surrounding said electrodes for generating an axial magnetic field.

5. Charged particle beam apparatus as defined in claim 2 further including means for accelerating the particles in the beam, means for mounting a target in the beam path, and means for causing relative motion between the beam and the target, such that said apparatus comprises an ion implantation system.

FIG. I

FIG.2

2/2

0225717

**European Patent Office**

## EUROPEAN SEARCH REPORT

Application number

| | DOCUMENTS CONSIDERED TO BE RELEVANT | | EP 86308472.9 |
|---|---|---|---|

| Category | Citation of document with indication, where appropriate, of relevant passages | Relevant to claim | CLASSIFICATION OF THE APPLICATION (Int. Cl 4) |
|---|---|---|---|
| Y | US - A - 4 174 479 (TUITHOF)<br>  * Fig. 1; column 2, lines 10-36 *<br>-- | 1 | H 01 J 37/317<br><br>H 01 J 49/30<br><br>H 01 J 37/145<br><br>H 01 L 21/265 |
| D,Y | NUCLEAR INSTRUMENTS & METHODS, vol. 151, May 1978, Amsterdam<br>R.BOOTH "Space Charge Lens for High Current Jon Eeams"<br>pages 143-147<br>  * Page 143, lines 6-10; page 144, left column, lines 5-24 *<br>-- | 1 | |
| Y<br>A | GB - A - 2 137 409 (VARIAN)<br>  * Fig. 1; page 1, lines 18-39 *<br>-- | 2<br>3 | |
| Y<br>A | IEEE TRANSACTIONS ON NUCLEAR SCIENCE, vol. NS-26, no. 3, part 1, June 1979, San Francisco<br>R.M.MOBLEY "Gabor Lenses"<br>pages 3112-3114<br>  * Page 3112, left column, lines 1-23; fig. 1a-1c; page 3113, left column, lines 20-27 *<br>---- | 2<br>4,5 | TECHNICAL FIELDS SEARCHED (Int. Cl 4)<br><br>H 01 J 37/00<br><br>H 01 J 49/00<br><br>H 01 L 21/00<br><br>B 01 D 59/00 |

The present search report has been drawn up for all claims

| Place of search | Date of completion of the search | Examiner |
|---|---|---|
| VIENNA | 18-02-1987 | BRUNNER |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503 03 82